# EUROPEAN PATENT APPLICATION

(11) **EP 2 535 444 A1**
(43) Date of publication of application: **19.12.2012**
(21) Application number: 10845790.4
(22) Date of filing: 27.10.2010
(51) Int. Cl.: C30B 29/36

(54) **METHOD FOR PRODUCING SILICON CARBIDE CRYSTAL AND SILICON CARBIDE CRYSTAL**

(30) Priority: 12.02.2010 JP 2010028895
(71) Applicant: Sumitomo Electric Industries, Ltd., Osaka-shi, Osaka 541-0041 (JP)
(72) Inventor: NISHIGUCHI, Taro, Itami-shi Hyogo 664-0016 (JP)
(74) Representative: Grünecker, Kinkeldey, Stockmair & Schwanhäusser
(86) International application number: PCT/JP2010/069082
(87) International publication number: WO 2011/099199

(57) **Abstract**

In a method of producing a SiC crystal by sublimation, the atmosphere gas for growing a SiC crystal contains He. The atmosphere gas may further contain N. The atmosphere gas may further contain at least one type of gas selected from the group consisting of Ne, Ar, Kr, Xe, and Rn. In the atmosphere gas, the partial pressure of He is preferably greater than or equal to 40%.

## Description

### TECHNICAL FIELD

The present invention relates to a method of producing a silicon carbide (SiC) crystal, and a SiC crystal.

### BACKGROUND ART

A SiC crystal is known to have a large band gap, as well as a maximum breakdown field and heat conductivity larger than those of silicon (Si), while the carrier mobility is of a comparable level to Si. The electron saturation drift rate and breakdown voltage are also great. Therefore, the expectation for application to semiconductor devices requiring high efficiency, high breakdown voltage, and large capacitance is great.

A method of producing a SiC crystal employed in such semiconductor devices is disclosed in, for example, Japanese Patent Laying-Open No. 2001-114599 (Patent Literature 1). Specifically, Patent Literature 1 teaches growing a SiC crystal on seed crystal by maintaining the temperature of seed crystal lower by approximately 10-100°C than the temperature of the SiC raw material powder through the heating by a heater in a vacuum vessel (heating furnace) into which argon (Ar) gas is introduced.

### CITATION LIST

### PATENT LITERATURE

PTL 1: Japanese Patent Laying-Open No. 2001-114599

### SUMMARY OF INVENTION

### TECHNICAL PROBLEM

In order to grow a SiC crystal, it is generally necessary to heat the SiC raw material at high temperature. The inventor of the present application found out that, if the pressure of the atmosphere is reduced in order to increase the growth rate of the SiC crystal, the growing conditions would become unstable according to the production method disclosed in the aforementioned Patent Literature 1. Due to the unstable growth conditions, the crystallinity of the grown SiC crystal was degraded.

The present invention is related to a SiC crystal, and a method of producing a SiC crystal, allowing favorable crystallinity of the SiC crystal.

### SOLUTION TO PROBLEM

The inventor studied diligently about the cause of the growing conditions rendered unstable. The inventor found out that the aforementioned problem was caused by, in the case where the growing atmosphere includes Ar gas, discharge through the ionization of Ar. The inventor found out that this problem is particularly noticeable when a SiC crystal is grown by the resistance-heating method in which the temperature of the heater is set higher than that of the crucible.

A method of producing a SiC crystal of the present invention is characterized in that the atmosphere gas for growing a SiC crystal contains helium (He) in the method of producing a silicon carbide (SiC) crystal by sublimation.

According to the method of producing a SiC crystal of the present invention, He that has higher ionization energy than that of Ar is used for the atmosphere gas. Since an ionized state of He can be suppressed, discharge will not occur even when a SiC crystal is grown under an atmosphere of extremely high temperature. Accordingly, the growing conditions can be stabilized, allowing favorable crystallinity of the produced SiC crystal.

Preferably in the method of producing a SiC crystal set forth above, the atmosphere gas further contains nitrogen (N).

N has low reactivity with the atmosphere gas and the crystal production device, and is an n-type dopant of SiC. Since an n type SiC crystal can be produced under stable growing conditions, favorable crystallinity of the produced n-type SiC crystal can be obtained.

Preferably in the method of producing a SiC crystal set forth above, the atmosphere gas further contains at least one type of gas selected from the group consisting of neon (Ne), Ar, krypton (Kr), xenon (Xe) and radon (Rn).

Even if the atmosphere gas further includes another noble gas, the growing condition can be rendered stable as long as He is contained.

Preferably in the method of producing a SiC crystal set forth above, the partial pressure of He is greater than or equal to 40% in the atmosphere gas. Preferably in the method of producing a SiC crystal set forth above, the pressure of the atmosphere for growing a SiC crystal is less than or equal to 300 Torr.

As a result of diligent study, the inventor found out that the growing conditions of a SiC crystal can be rendered further stable by controlling the He partial pressure and the pressure of the atmosphere to be within the range set forth above. Therefore, the crystallinity of the produced SiC crystal can be rendered more favorable.

Preferably in the method of producing a SiC crystal set forth above, a SiC crystal is grown by resistance-heating.

The growing condition can be rendered stable by virtue of the atmosphere gas containing He, as set forth above. Therefore, even in the case where a SiC crystal is grown according to the resistance-heating method in which the temperature of the heater is set higher than the heating temperature of the crucible, the growing conditions can be rendered stable. Furthermore, since the resistance-heating method allows the temperature distribution of the crucible in which a SiC crystal is grown to be controlled readily, the crystallinity of the produced SiC crystal can be rendered more favorable.

Preferably in the method of producing a SiC crystal set forth above, a SiC crystal is grown by a resistance-heating method using a heater made of graphite.

Accordingly, heating at a high temperature greater than or equal to 2000°C is allowed. Therefore, the crystallinity of the produced SiC crystal can be rendered further favorable.

A SiC crystal of the present invention is produced by any of the above-described method of producing a SiC crystal. The SiC crystal of the present invention is a single crystal. Since the SiC crystal of the present invention can be produced under stable growing conditions during crystal growth, a single crystal with favorable crystallinity can be obtained.

Preferably in the SiC crystal set forth above, the crystal polymorph (polytype) is 4H-SiC. Thus, the material for a device of high breakdown voltage can be realized.

### ADVANTAGEOUS EFFECTS OF INVENTION

Since the atmosphere gas contains He according to the SiC crystal and method of manufacturing a SiC crystal of the present invention, the crystallinity of the SiC crystal can be rendered favorable.

### BRIEF DESCRIPTION OF DRAWINGS

Fig. 1 is a schematic sectional view of a SiC crystal according to an embodiment of the present invention.
Fig. 2 is a schematic sectional view of a production device that can be used in producing a SiC crystal according to an embodiment of the present invention.
Fig. 3 is an enlarged sectional view of a crucible according to an embodiment of the present invention.
Fig. 4 is a schematic sectional view taken along line IV-IV of Fig. 2.
Fig. 5 is a schematic sectional view to describe a producing step of a SiC crystal according to a comparative example.

### DESCRIPTION OF EMBODIMENTS

Embodiments of the present invention will be described hereinafter with reference to the drawings. In the drawings, the same or corresponding elements have the same reference character allotted, and description thereof will not be repeated.

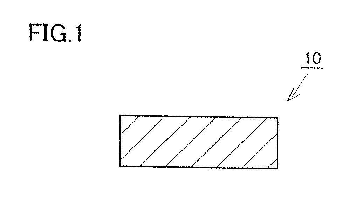

First, a SiC crystal 10 according to an embodiment of the present invention will be described hereinafter with reference to Fig. 1. SiC crystal 10 is a single crystal, having favorable crystallinity. The polytype of SiC crystal 10 is preferably, but not limited to, 4H-SiC.

A method of producing SiC crystal 10 of the present embodiment will be described with reference to Figs. 1-4.

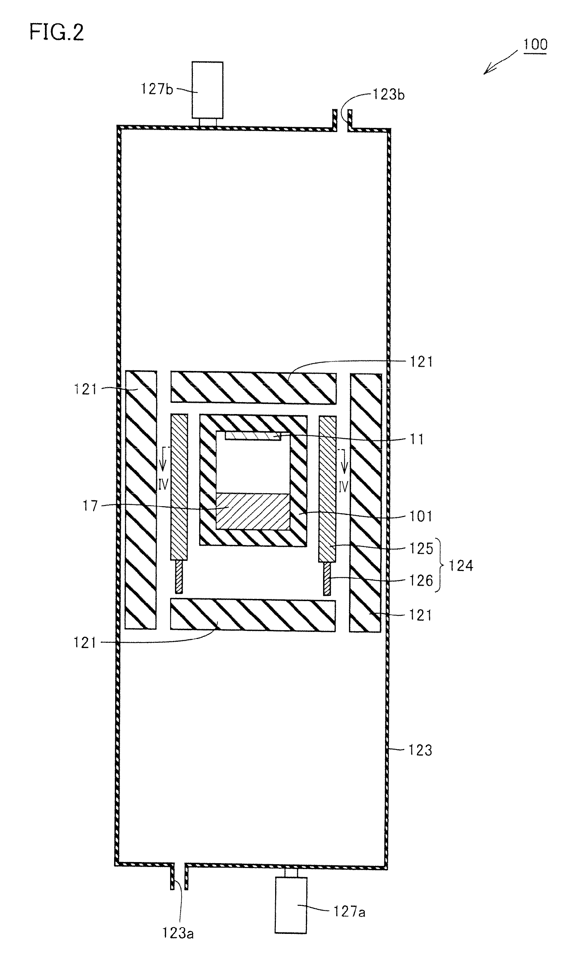

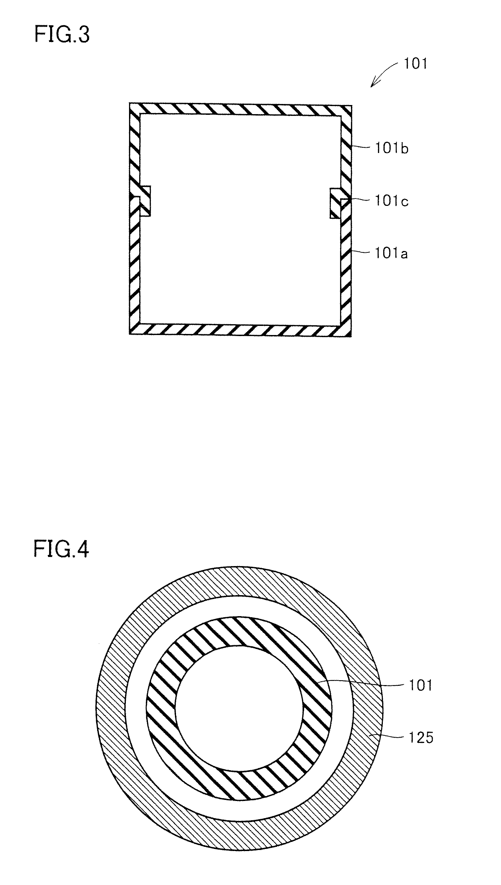

First, a production device 100 for SiC crystal 10 shown in Figs. 2-4 is prepared. The main configuration of production device 100 for SiC crystal 10 will be described with reference to Figs. 2 and 3. Production device 100 grows a SiC crystal by sublimation. Specifically, production device 100 grows SiC crystal 10 by sublimating raw material 17 containing SiC for deposition of the sublimated raw material gas on seed crystal 11.

As shown in Fig. 2, production device 100 mainly includes a crucible 101, an insulator 121, reaction vessel 123, and a heating unit 124.

Crucible 101 has seed crystal 11 and raw material 17 arranged therein. Crucible 101 is preferably made of graphite, for example. Since graphite is stable at high temperature, cracking of crucible 101 can be suppressed. Furthermore, since C constituting crucible 101 is a constituent element of the SiC crystal, the C of crucible 101, even if sublimated to be introduced into the SiC crystal, will not become the impurity. Therefore, the crystallinity of the produced SiC crystal can be rendered more favorable.

As shown in Fig. 3, crucible 101 includes a bottom section 101a for storing raw material therein, and a lid section 101b for arranging seed crystal 11 inside. Lid section 101b has its edge bent to be fitted into bottom section 101a. Bottom section 101a and lid section 101b are connected at a connection section 101c.

As shown in Figs. 2 and 4, heating unit 124 surrounds the outer circumference of crucible 101 to heat the interior of crucible 101. Heating unit 124 includes a heater 125 and an electrode 126. Heater 125 is, for example, a graphite heater. Electrode 126 is made of, for example, copper (Cu).

Heating unit 124 is not limited to the system by resistance-heating, and may be a high frequency heating coil or the like.

Insulator 121 surrounds the outer circumference of heating unit 124. Insulator 121 is preferably made of carbon felt, for example. Since carbon felt has a heat insulating effect and can suppress change in the growing conditions during the growing of a SiC crystal, the crystallinity of the produced SiC crystal can be rendered favorable.

Reaction vessel 123 is provided around insulator 121. At the two ends of reaction vessel 123 are formed a gas inlet 123a for introducing atmosphere gas into reaction vessel 123 and a gas outlet 123b for discharging atmosphere gas outside of reaction vessel 123.

Above and below reaction vessel 123 are provided radiation thermometers 127b and 127a, respectively, for measuring the temperature above and below crucible 101.

Production device 100 may include various elements other than those set forth above. For the sake of convenience, illustration and the description of such other elements are not shown here.

As shown in Fig. 2, raw material 17 is arranged in crucible 101. Raw material 17 may be powder or a sintered compact. For example, polycrystalline SiC powder or SiC sintered compact is prepared. In the present embodiment, raw material 17 is arranged at the lower portion of crucible 101.

As shown in Fig. 2, seed crystal 11 is arranged to face raw material 17 in crucible 101. In the present embodiment, seed crystal 11 is arranged at the upper section of crucible 101 so as to face raw material 17. The crystal structure of seed crystal 11 is not particularly limited, and may be the same as or different from the crystal structure of SiC crystal 10 to be grown. For the standpoint of improving the crystallinity of grown SiC crystal 10, a SiC crystal having the same crystal structure is preferably prepared as seed crystal 11.

In crucible 101, raw material 17 is heated to be sublimated to cause deposition of raw material gas on seed crystal 11, whereby SiC crystal 10 is grown. The atmosphere for growing SiC crystal 10 is atmosphere gas containing He.

Specifically, gas containing He flows into reaction vessel 123 through gas inlet 123a of reaction vessel 123. Accordingly, reaction vessel 123 is filled with gas containing He. Gas containing He can be made to flow into crucible 101 from connection section 101c of crucible 101. Accordingly, the interior of crucible 101 includes atmosphere gas containing He.

Then, raw material 17 is heated by heating unit 124 as high as the sublimation temperature of raw material 17. Although not particularly limited, the heating preferably includes resistance-heating, more preferably resistance-heating using graphite heater 125. The high frequency heating method may also be employed. By this heating, raw material 17 is sublimated to generate sublimation gas (raw material gas).

The sublimation gas is solidified again on the surface of seed crystal 11 arranged at a temperature lower than that of raw material 17. As an example of the growth temperature, the temperature of raw material 17 is maintained greater than or equal to 2300°C and less than or equal to 2400°C, whereas the temperature of seed crystal 11 is maintained greater than or equal to 2100°C and less than or equal to 2200°C. Accordingly, a SiC crystal is grown on seed crystal 11. The growth temperature is maintained at a constant temperature, or varied at a certain ratio during growing.

In the present step, the aforementioned atmosphere gas may further contain nitrogen such as N₂ gas. In this case, an n-type SiC crystal 10 can be grown since N is an n-type dopant. Although C is suitable for the material of crucible 101, insulator 121, and the like, N₂ gas has low reactivity with C, as compared to other dopants. Moreover, N₂ gas does not require a specific facility, as compared to other dopants, leading to reduction in cost.

The atmosphere gas may further include at least one type of gas selected from the group consisting of Ne, Ar, Kr, Xe and Rn. The effect achieved by containing He can be exhibited even if the atmosphere gas contains such noble gas. Atmosphere gas containing Ar is advantageous in that the fabrication cost can be reduced and the heat conductivity improved.

In the atmosphere gas, the partial pressure of He is preferably greater than or equal to 40%, more preferably greater than or equal to 60%, furthermore preferably greater than or equal to 80%. In this case, occurrence of discharge can be suppressed effectively.

In the step of growing a SiC crystal 10 set forth above, the pressure of the atmosphere for growth is preferably less than or equal to 300 Torr, more preferably less than or equal to 50 Torr, furthermore preferably less than or equal to 30 Torr. In this case, the growth rate can be increased.

Then, the interior of production device 100 is cooled down to ambient temperature. The produced SiC crystal 10 is taken out from production device 100. Thus, SiC crystal 10 (SiC ingot) shown in Fig. 1 including seed crystal 11 and the SiC crystal formed on seed crystal 11 can be produced.

SiC crystal 10 shown in Fig. 1 may be produced by removing seed crystal 11 from the SiC ingot. In the case where removal is to be performed, seed crystal 11 alone, or seed crystal 11 and a portion of the grown SiC crystal, may be removed.

The method of removing is not particularly limited. For example, a mechanical way such as cutting, grinding, or cleavage may be employed. Cutting refers to removing at least seed crystal 11 from the SiC ingot by means of machinery such as a slicer or the like having a peripheral cutting edge of a diamond electrodeposition wheel. Grinding refers to grinding off the surface in the thickness direction by bringing a grindstone into contact with the surface while rotating. Cleavage refers to dividing the crystal along a crystal lattice plane. A chemical removing method such as etching may also be employed.

In the case where the produced SiC crystal 10 is thick, SiC crystal 10 shown in Fig. 1 may be produced by cutting out a plurality of layers of SiC crystal from the grown SiC crystal. In this case, the production cost per one SiC crystal 10 can be reduced.

Then, one side or both sides of the SiC crystal may be planarized by grinding, polishing, or the like, as necessary.

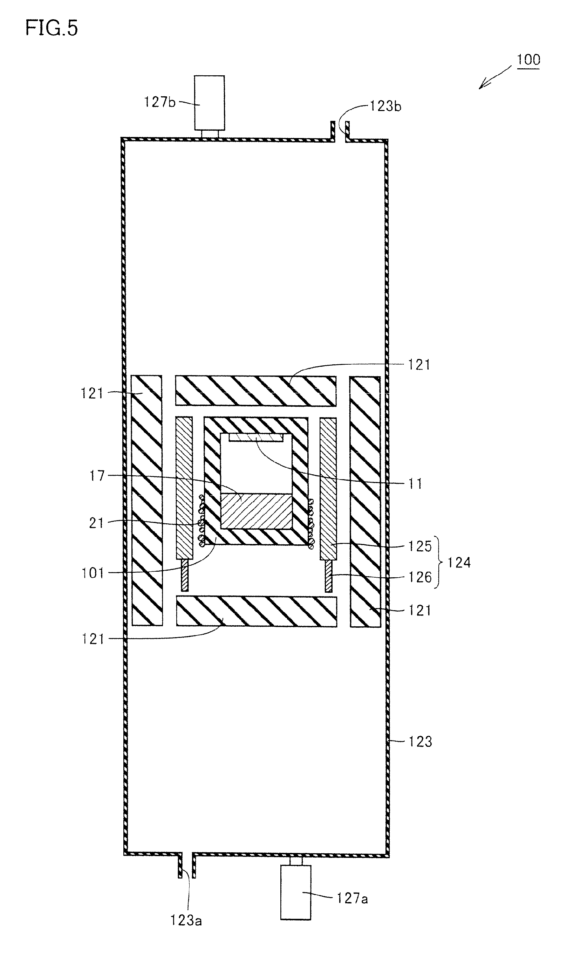

The advantage of the method of producing SiC crystal 10 according to the present embodiment will be described hereinafter in comparison with the method of producing a SiC crystal according to Patent Literature 1 shown in Fig. 5.

The method of producing a SiC crystal according to Patent Literature 1 is based on a configuration basically similar to that of the method of producing a SiC crystal 10 of the present embodiment, and differs in that the atmosphere for growing a SiC crystal includes Ar gas.

If the pressure is reduced for the purpose of increasing the growth rate of the SiC crystal when the atmosphere gas includes Ar, discharge occurs by ionization of Ar. This is considered to be caused by ionization of Ar in the neighborhood of heating unit 124 that is a region of high temperature in production device 100. In this case, deposition of deposits 21 occurs at the outer circumference of crucible 101 corresponding to the side where raw material 17 is arranged, i.e. the outer circumferential region heated to a relatively high temperature, as shown in Fig. 5. In the case where insulator 121 includes C, for example, deposits 21 are C, having a black color.

The occurrence of discharge of the atmosphere gas renders the growing conditions unstable such as temperature variation. Unstable growing conditions will cause a defect in the grown SiC crystal and/or modifies the polytype to an unintended type. Accordingly, the crystallinity of the produced SiC crystal will be degraded.

In contrast, the atmosphere for growing SiC crystal 10 (atmosphere gas) in the present embodiment contains He. He is advantageous in that electrons do not readily ionize due to higher ionization energy than Ar. Since an ionized state of He can be suppressed, discharge will not occur even in the case where a SiC crystal is grown in an atmosphere of extremely high temperature. It can be confirmed that discharge is suppressed in the present embodiment from the fact that generation of deposits 21 (Fig. 5) can be reduced. Since the growing conditions can be rendered stable, generation of a defect in the produced SiC crystal 10 is suppressed, and SiC crystal 10 exhibiting the intended polytype is obtained. Thus, the crystallinity of SiC crystal 10 can be made favorable.

### EXAMPLE 1

The advantage of containing He in the atmosphere gas for growing a SiC crystal was studied in the present example.

### (Inventive Examples 1-6)

In Examples 1-6 of the present invention, a SiC crystal 10 was produced according to the method of producing a SiC crystal set forth in the foregoing embodiment.

Specifically, graphite-made crucible 101 of the configuration shown in Fig. 3 was first prepared. Crucible 101 had an outer diameter of 140 mm, an inner diameter of 120 mm, and a height of 100 mm.

Heating unit 124 including graphite heater 125 and Cu electrode 126 was arranged at the outer circumference of crucible 101. Insulator 121 made of carbon felt was arranged at the outer circumference of crucible 101 and heating unit 124.

Raw material 17 was arranged at the lower section in crucible 101. SiC powder was used for raw material 17. Seed crystal 11 was arranged at the upper section in crucible 101 so as to face raw material 17. For seed crystal 11, 4H-SiC having an outer diameter of 75 mm was used.

For the atmosphere gas in reaction vessel 123, He gas and N₂ gas were introduced at the flow rate of 0.5 slm and 0.1 slm, respectively, and the temperature in crucible 101 was boosted by heating unit 124. Following the arrival of the value indicated by radiation thermometer 127a that measures the temperature of crucible 101 at the side of raw material 17 at a predetermined temperature, the power was controlled according to the pressure in crucible 101 indicated in Table 1 set forth below such that the measured temperature by radiation thermometer 127a at the side of raw material 17 attains 2400°C and the temperature by radiation thermometer 127b at the side of seed crystal 11 attains 2200°C. Accordingly, SiC gas was sublimated from raw material 17 to grow a SiC crystal on seed crystal 11 for 50 hours as the growing duration. Then, production device 100 was cooled such that the interior became as low as the ambient temperature. Thus, a SiC crystal was produced.

### (Comparative Examples 1-6)

The method of producing a SiC crystal in each of Comparative Examples 1-6 was basically similar to that of Inventive Examples 1-6, provided that atmosphere gas based on Ar gas at the flow rate of 0.5 slm and N₂ gas at the flow rate of 0.1 slm was employed. Namely, the method of producing a SiC crystal in each of Comparative Examples 1-6 differed from Inventive Examples 1-6 in the usage of Ar gas instead of He gas.

### (Way of Measurement)

For Inventive Examples 1-6 and Comparative Examples 1-6, the ratio of the range of variation of the current relative to the average current value was measured as the heater current range of variation. The results are shown in Table 1 set forth below. A smaller range of variation of the heater current implies that discharge has not occurred. In Table 1, "<1" implies less than 1%, and "1-2" implies greater than or equal to 1% and less than or equal to 2%.

**Table 1**

| | Atmosphere Gas | Pressure (Torr) | Heater Current Range of variation (%) |
|---|---|---|---|
| Inventive Example 1 | He | 600 | <1 |
| Inventive Example 2 | He | 300 | <1 |
| Inventive Example 3 | He | 100 | <1 |
| Inventive Example 4 | He | 50 | <1 |
| Inventive Example 5 | He | 30 | <1 |
| Inventive Example 6 | He | 10 | <1 |
| Comparative Example 1 | Ar | 600 | 1-2 |
| Comparative Example 2 | Ar | 300 | 1-2 |
| Comparative Example 3 | Ar | 100 | 1-2 |
| Comparative Example 4 | Ar | 50 | 5-10 |
| Comparative Example 5 | Ar | 30 | 10-20 |
| Comparative Example 6 | Ar | 10 | 25-30 |

### (Result of Measurements)

As shown in Table 1, the heater current range of variation of Inventive Examples 1-6 containing He as atmosphere gas was less than 1%. It was therefore identified that discharge could be suppressed by using atmosphere gas containing He.

Further, as shown in Table 1, each of Inventive Examples 1-6 employing atmosphere gas containing He had the heater current range of variation reduced, i.e. discharge suppressed, as compared to Comparative Examples 1-6 using atmosphere gas not containing He under the same pressure.

Moreover, it was identified that discharge could be suppressed significantly when the pressure of the atmosphere is less than or equal to 300 Torr, more preferably less than or equal to 50 Torr.

Thus, it was confirmed that discharge could be suppressed by using atmosphere gas containing He for growing a SiC crystal according to the present example. It is appreciated that the crystallinity of the produced SiC crystal can be rendered favorable since the growing conditions are rendered stable by suppressing discharge.

### EXAMPLE 2

The advantage of using atmosphere gas containing He for growing a SiC crystal was further studied in the present example.

### (Inventive Examples 7-12 and Comparative Examples 7-12)

The method of producing a SiC crystal in Inventive Examples 7-12 and Comparative Examples 7-12 was basically similar to that of Inventive Examples 1-6 and Comparative Examples 1-6, provided that the temperature at the side of raw material 17 was set at 2300°C. Specifically, in the step of growing a SiC crystal, the power was controlled such that the temperature measured by radiation thermometer 127a at the side of raw material 17 attains 2300°C and the temperature measured by radiation thermometer 127b at the side of seed crystal 11 attains 2100°C.

### (Way of Measurement)

For Inventive Examples 7-12 and Comparative Examples 7-12, the heater current range of variation was measured, likewise with Inventive Examples 1-6 and Comparative Examples 1-6. The results are indicated in Table 2 set forth below.

**Table 2**

| | Atmosphere Gas | Pressure (Torr) | Heater Current Range of variation (%) |
|---|---|---|---|
| Inventive Example 7 | He | 600 | <1 |
| Inventive Example 8 | He | 300 | <1 |
| Inventive Example 9 | He | 100 | <1 |
| Inventive Example 10 | He | 50 | <1 |
| Inventive Example 11 | He | 30 | <1 |
| Inventive Example 12 | He | 10 | <1 |
| Comparative Example 7 | Ar | 600 | 1-2 |
| Comparative Example 8 | Ar | 300 | 1-2 |
| Comparative Example 9 | Ar | 100 | 1-2 |
| Comparative Example 10 | Ar | 50 | 3-5 |
| Comparative Example 11 | Ar | 30 | 10-20 |
| Comparative Example 12 | Ar | 10 | 20-30 |

### (Result of Measurement)

As shown in Table 2, the heater current range of variation of Inventive Examples 7-12 using atmosphere gas containing He was less than 1%. It was therefore identified that discharge could be suppressed by using atmosphere gas containing He.

Furthermore, as shown in Table 2, each of Inventive Examples 7-12 employing atmosphere gas containing He had the heater current range of variation reduced, i.e. discharge suppressed, as compared to Comparative Examples 7-12 using atmosphere gas not containing He under the same pressure.

Moreover, it was identified that discharge could be suppressed significantly when the pressure of the atmosphere is less than or equal to 100 Torr, more preferably less than or equal to 50 Torr.

Thus, it was confirmed that discharge could be suppressed by using atmosphere gas containing He for growing a SiC crystal according to the present example. It is appreciated that the crystallinity of the produced SiC crystal can be rendered favorable since the growing conditions are rendered stable by suppressing discharge.

### EXAMPLE 3

The advantage of containing He in the atmosphere gas for growing a SiC crystal was further studied in the present example. In addition, the preferable range of the partial pressure of He in the atmosphere gas was also studied.

### (Inventive Examples 13-17)

Inventive Examples 13-17 were basically similar to Inventive Example 12, provided that the atmosphere gas differed. Specifically, no N₂ gas flow was employed. Furthermore, in Inventive Examples 14-17, Ar gas was introduced together with He gas so as to attain the partial pressure (He/(He+Ar)) shown in Table 3 set forth below. Namely, the atmosphere gas of Inventive Example 13 was based on He alone, whereas the atmosphere gas of Inventive Examples 14-17 was based on He and Ar. The partial pressure was obtained by the equation of "He partial pressure/(He partial pressure+Ar partial pressure)".

### (Inventive Examples 18-22)

Inventive Examples 18-22 were basically similar to Inventive Example 11, provided that the atmosphere gas differed. Specifically, no N₂ gas flows was employed. Furthermore, in Inventive Examples 19-22, Ar gas was introduced together with He gas so as to attain the partial pressure (He/(He+Ar)) shown in Table 3 set forth below. Namely, the atmosphere gas of Inventive Example 18 was based on He alone, whereas the atmosphere gas of Inventive Examples 19-22 was based on He and Ar.

### (Comparative Examples 13 and 14)

Each of Comparative Examples 13 and 14 was basically similar to Inventive Examples 13 and 18, respectively, provided that Ar gas was used instead of He gas. Namely, the atmosphere gas used in Comparative Examples 13 and 14 was based on Ar alone.

### (Way of Measurement)

For Inventive Examples 13-22 and Comparative Examples 13 and 14, the range of variation of the heater current was measured, likewise with Inventive Examples 1-6 and Comparative Examples 1-6. The results are shown in Table 3 set forth below.

**Table 3**

| | He/(He+Ar) (%) | Pressure (Torr) | Heater Current Range of variation (%) |
|---|---|---|---|
| Inventive Example 13 | 100 | 10 | <1 |
| Inventive Example 14 | 80 | 10 | <1 |
| Inventive Example 15 | 60 | 10 | 1-2 |
| Inventive Example 16 | 40 | 10 | 1-2 |
| Inventive Example 17 | 20 | 10 | 10-20 |
| Inventive Example 18 | 100 | 30 | <1 |
| Inventive Example 19 | 80 | 30 | <1 |
| Inventive Example 20 | 60 | 30 | <1 |
| Inventive Example 21 | 40 | 30 | 1-2 |
| Inventive Example 22 | 20 | 30 | 1-2 |
| Comparative Example 13 | 0 | 10 | 25-35 |
| Comparative Example 14 | 0 | 30 | 10-20 |

### (Result of Measurement)

Further, as shown in Table 3, each of Inventive Examples 13-17 and 18-22 employing atmosphere gas containing He had the heater current range of variation reduced, i.e. discharge suppressed, as compared to Comparative Examples 13 and 14 using atmosphere gas not containing He under the same pressure.

Moreover, Inventive Examples 13-16 and 18-21 with He partial pressure greater than or equal to 40% had the heater current range of variation further reduced, i.e. had discharge further suppressed, as compared to Inventive Examples 17 and 22 differing in only the partial pressure of He (differing in that the He partial pressure is less than 40%) under the same pressure.

Thus, it was confirmed that discharge could be suppressed by using atmosphere gas containing He for growing a SiC crystal according to the present example. Moreover it was confirmed that discharge could be further suppressed by setting the partial pressure of He greater than or equal to 40%.

Although the present invention has been described based on embodiments and examples as set forth above, it is intended that the features of the embodiments and examples may be combined appropriately. Furthermore, it should be understood that the embodiments and examples disclosed herein are illustrative and nonrestrictive in every respect. The scope of the present invention is defined by the terms of the claims, rather than the embodiments and examples set forth above, and is intended to include any modification within the scope and meaning equivalent to the terms of the claims.

### REFERENCE SIGNS LIST

10 SiC crystal; 11 seed crystal; 17 raw material; 21 deposit; 100 production device; 101 crucible; 101a bottom section; 101b lid section; 101c connection section; 121 insulator; 123 reaction vessel; 123a gas inlet; 123b gas outlet; 124 heating unit; 125 heater; 126 electrode; 127a, 127b radiation thermometer.

## Claims

1. A method of producing a silicon carbide crystal (10) by sublimation, wherein atmosphere gas for growing said silicon carbide crystal (10) contains helium.

2. The method of producing a silicon carbide crystal (10) according to claim 1, wherein said atmosphere gas further contains nitrogen.

3. The method of producing a silicon carbide crystal (10) according to claim 1, wherein said atmosphere gas further contains at least one type of gas selected from the group consisting of neon, argon, krypton, xenon and radon.

4. The method of producing a silicon carbide crystal (10) according to claim 1, wherein partial pressure of helium in said atmosphere gas is greater than or equal to 40%.

5. The method of producing a silicon carbide crystal (10) according to claim 1, wherein pressure of the atmosphere for growing said silicon carbide crystal (10) is less than or equal to 300 Torr.

6. The method of producing a silicon carbide crystal (10) according to claim 1, wherein said silicon carbide crystal (10) is grown by a resistance-heating method.

7. The method of producing a silicon carbide crystal (10) according to claim 6, wherein said silicon carbide crystal (10) is grown by said resistance-heating method using a heater made of graphite.

8. A silicon carbide crystal (10) produced by the method of producing a silicon carbide crystal (10) defined in claim 1, wherein said silicon carbide crystal (10) is a single crystal.

9. The silicon carbide crystal (10) according to claim 8, wherein a crystal polymorph is 4H-SiC.
